Europäisches Patentamt

(19) European Patent Office

Office européen des brevets

(11) Publication number: **0 072 640**
**B1**

## (12) EUROPEAN PATENT SPECIFICATION

(45) Date of publication of patent specification: **22.10.86**

(21) Application number: **82304042.3**

(22) Date of filing: **30.07.82**

(51) Int. Cl.⁴: **G 11 B 5/09, G 06 F 11/10**

(54) Methods of data error correction.

(30) Priority: **14.08.81 JP 127595/81**

(43) Date of publication of application:
**23.02.83 Bulletin 83/08**

(45) Publication of the grant of the patent:
**22.10.86 Bulletin 86/43**

(84) Designated Contracting States:
**AT DE FR GB IT NL**

(56) References cited:
**FR-A-2 400 801**
**FR-A-2 440 125**
**FR-A-2 450 540**
**GB-A-1 445 439**
**GB-A-2 079 993**

(73) Proprietor: **SONY CORPORATION**
**7-35 Kitashinagawa 6-Chome Shinagawa-ku**
**Tokyo 141 (JP)**

(72) Inventor: **Sako, Yoichiro**
**2-25-3 Kitamagome**
**Ohta-ku Tokyo (JP)**
Inventor: **Odaka, Kentaro**
**3245-1-307 Nobotito**
**Tama-ku Kanagawa-ken (JP)**

(74) Representative: **Thomas, Christopher Hugo**
**et al**
**D Young & Co 10 Staple Inn**
**London WC1V 7RD (GB)**

Courier Press, Leamington Spa, England.

# 0 072 640

## Description

This invention relates to methods of data error correction.

For a data transmission method effective against burst errors, we have previously proposed a method called a cross-interleave technique. In this cross-interleave technique one word contained in each of the pulse code modulated (PCM) data series in a plurality of channels in a first arrangement state is supplied to a first error correcting encoder so as to produce a first check word series. This first check word series and the PCM data series in the plurality of channels are then rearranged into a second arrangement state, and one word contained therein is supplied to a second error correcting encoder to allow a second check word series to be produced. In other words, a double interleave (comprising rearrangements of check words and data) is performed in word units.

A so-called interleave technique is one which, prior to transmission (which term includes recording), disperses the check words and the PCM data contained in a common error correcting block, so that when they are put back into the original arrangement state after reception (which term includes reproduction), the number of error words in the plurality of words contained in any one error correcting block is reduced. That is, when burst errors occur in the transmission of data, such burst errors can be dispersed. If such an interleave technique is performed twice, the first and second check words respectively form independent error correcting blocks so that even when errors cannot be corrected by any one of the check words, such errors may be correctable by the other check word.

However, in the cross-interleave technique as referred to above, if only one bit in a word is erroneous, the whole of the word is treated as erroneous, so that if the received data contains a relatively large number of random errors, the loss of data may be serious.

Therefore, consideration has been given to combining an error correcting code (such as a b-adjacent code) having high error correcting ability and able to correct K words within one block, for example up to two word errors, and when the error location is known, M words within one block, for example up to four word errors, with the foregoing cross or multi-interleave. When only one word error is intended to be corrected, the above error correcting code enables the construction of the decoder to be relatively simple.

Also, when the second error correcting block is decoded at the first stage and restored to the first arrangement state so as to decode the first error correcting block at the next stage, if an error in the decoding at the first stage is wrongly identified as the absence of error, and four word errors are detected as one word error with resulting erroneous correction, then this erroneous identification and erroneous correction cause further missing of error detection and erroneous correction during the decoding at the next stage. Thus the possibility of misoperation is increased. Moreover, if the number of error words to be corrected is increased, the probability of missing errors and erroneous correction is generally increased.

In connection with the above-mentioned methods see, in particular our UK patent specification GB—A—2 079 993, (published 27.01.82 and thus not belonging to the prior art) and also our UK patent specification GB—A—2 045 036 and "A new class of burst-error-correcting codes and its application to PCM tape recording systems" by Inoue, Sugiyama, Ohnishi, Kanai and Tanaka presented at the National Telecommunications Conference of the IEEE, 1978.

According to the present invention there is provided a method of error correction of a pulse code modulated data sequence in which first and second error correcting blocks have been formed, each of said first error correcting blocks comprising a plurality of data words contained in said pulse code modulated data sequence and first check words generated therefrom and associated therewith, each of said second error correcting blocks having been derived by subjecting said words of each of said first error correcting blocks to respective different delays so as to interleave said words, and each of said second error correcting blocks comprising a plurality of data words, each of which is included in a different one of said first error correcting blocks, and second check words generated therefrom and associated therewith, the method of error correction comprising the steps of:

first decoding said second error correcting blocks in a first stage;
said first decoding including the steps of:
detecting the error-status of said data words in said second error correcting blocks; and
adding a respective pointer to each erroneous said data word;
de-interleaving said data words to re-form said first error correcting blocks;
second decoding said first error correcting blocks in a second stage; and
processing said data words on the basis of said pointers so as to correct or compensate each said erroneous data word; characterized in that:
said first decoding includes the steps of detecting one of more than two types of error-status, such as no error, one-word error, two-word error, in said second error correcting blocks;
correcting at least said one-word errors; and
adding a respective pointer consisting of a plurality of bits and corresponding respectively to said types of error-status to each of data words so as to distinguish said error-status;
said second decoding includes the step of correcting further errors; and
said processing of said data words includes the subsequent step of discriminating the kind of said pointers and processing said data words on the basis of the result of said discrimination so as to correct

2

each of said erroneous data words when the number of said erroneous data words is discriminated to be within the error correction capability and otherwise to compensate each of said erroneous data words.

The invention will now be described by way of example with reference to the accompanying drawings, throughout which like references designate like elements, and in which:

Figure 1 (formed of Figures 1A and 1B) is a block diagram showing an example of an error correcting encoder to which this invention is applied;

Figure 2 is a block diagram showing an arrangement of data upon transmission;

Figure 3 (formed of Figures 3A and 3B) is a block diagram showing an example of an error correcting decoder to which this invention is applied;

Figures 4 and 5 are diagrams used to explain the operation of the error correcting decoder; and

Figures 6 to 8 are flow charts used to explain the operation of a partially modified decoder.

First, an error correcting code will be described.

In general, to describe the error correcting code, an expression using vector representation or a cyclic group is employed. First of all, on a Galois field GF(2), an irreducible polynomial $F(x)$ of order m is considered. On the Galois field GF(2) there exist only elements "0" and "1", and the irreducible polynomial $F(x)$ has no root. Therefore, a hypothetical or imaginary root $\alpha$ to satisfy $F(x)=0$ is considered. At this time, $2^m$ elements $0, \alpha, \alpha^2, \alpha^3, \ldots, \alpha^{2^m-1}$, each of which differs from the other elements, and expressed by a power of $\alpha$ including the zero element, constitute an extension field $GF(2^m)$. The extension field $GF(2^m)$ is the polynomial ring taking the irreducible polynomial $F(x)$ of order m on the Galois field GF(2) as a modulus. The elements of the extension field $GF(2^m)$ can be written by a linear combination of:

$$1, \alpha=\{x\}, \alpha^2=\{x^2\}, \ldots, \alpha^{m-1}=\{x^{m-1}\}$$

that is:

$$a_0=a_1\{x\}+a_2\{x^2\}+ \ldots +a_{m-1}\{x^{m-1}\}$$

$$=a_0+a_1\alpha+a_2\alpha^2+ \ldots +a_{m-1}\alpha^{m-1}$$

or:

$$(a_{m-1}, a_{m-2}, \ldots, a_2, a_1, a_0)$$

where:

$$a_0, a_1, \ldots, a_{m-1}\varepsilon GF(p)$$

By way of example, the extension field $GF(2^8)$ is considered. By $(\text{mod. } F(x)=x^8+x^4+x^3+x^2+1)$, all data of eight bits can be written as:

$$a_7x^7+a_6x^6+a_5x^5+a_4x^4+a_3x^3+a_2x^2+a_1x+a_0$$

or:

$$(a_7, a_6, a_5, a_4, a_3, a_2, a_1, a_0)$$

thus $a_7$ is assigned to the most significant bit (MSB) and $a_0$ to the least significant bit (LSB). In this case, $a_n$ belongs to the Galois field GF(2) and it is therefore either "0" or "1".

Also, from the polynomial $F(x)$ is derived the following m×m matrix:

$$T=\begin{bmatrix} 0 & 0 & \ldots & 0 & a_0 \\ 1 & 0 & \ldots & 0 & a_1 \\ 0 & 1 & \ldots & 0 & a_2 \\ \cdot & \cdot & & \cdot & \cdot \\ \cdot & \cdot & & \cdot & \cdot \\ \cdot & \cdot & & \cdot & \cdot \\ 0 & 0 & \ldots & 1 & a_{m-1} \end{bmatrix}$$

There is another expression which uses the cyclic group, which takes advantage of the fact that the remainder elements, excluding the zero element, from the extension field $GF(2^m)$ form a multiplicative group of order $2^m-1$. If the elements of the extension field $GF(2^m)$ are represented by the use of the cyclic group, they become:

$$0, 1(=\alpha^{2^m-1}), \alpha, \alpha^2, \alpha^3, \ldots, \alpha^{2^m-2}$$

0 072 640

In one method according to the invention, when m bits constitute one word and n words constitute one block, k check words are produced on the basis of the following parity check matrix:

$$H = \begin{bmatrix} 1 & 1 & \ldots 1 & 1 \\ \alpha^{n-1} & \alpha^{n-2} & \ldots \alpha & 1 \\ \alpha^{2(n-1)} & \alpha^{2(n-2)} & \ldots \alpha^2 & 1 \\ . & . & . & . \\ . & . & . & . \\ . & . & . & . \\ \alpha^{(k-1)(n-1)} & \alpha^{(k-1)(n-2)} & \ldots \alpha^{k-1} & I \end{bmatrix}$$

Also, by the matrix T, the parity check matrix H is similarly expressible as:

$$H = \begin{bmatrix} I & I & \ldots I & I \\ T^{n-1} & T^{n-2} & \ldots T^1 & I \\ T^{2(n-1)} & T^{2(n-2)} & \ldots T^2 & I \\ . & . & . & . \\ . & . & . & . \\ . & . & . & . \\ T^{(k-1)(n-1)} & T^{(k-1)(n-2)} & \ldots T^{k-1} & I \end{bmatrix}$$

where I represents a unit matrix of $(m \times m)$.

The representation using the root $\alpha$ and the representation using the generating matrix H are both substantially the same.

Further, taking a case where four $(k=4)$ check words are employed as an example, the parity check matrix H becomes:

$$H = \begin{bmatrix} 1 & 1 & \ldots 1 & 1 \\ \alpha^{n-1} & \alpha^{n-2} & \ldots \alpha & 1 \\ \alpha^{2(n-1)} & \alpha^{2(n-2)} & \ldots \alpha^2 & 1 \\ \alpha^{3(n-1)} & \alpha^{3(n-2)} & \ldots \alpha^3 & 1 \end{bmatrix}$$

Let one block of the received data be a column vector:

$$V = (\hat{W}_{n-1}, \hat{W}_{n-2}, \ldots \hat{W}_1, \hat{W}_0)$$

(where $\hat{W}_i = W_i \oplus e_i$, $e_i$ being the error pattern). Then, four syndromes $S_0$, $S_1$, $S_2$ and $S_3$ produced at the receiver are:

$$\begin{bmatrix} S_0 \\ S_1 \\ S_2 \\ S_3 \end{bmatrix} = H \cdot V^T$$

This error correcting code is capable of correcting up to two word errors within one error correcting block, and when the error location is known, up to three word errors or four word errors can be corrected.

4

One block includes therein four check words ($p=W_3$, $q=W_2$, $r=W_1$ and $s=W_0$), which are obtained as follows, where $\Sigma$ implies

$$\sum_{i=4}^{n-1}$$

$$\left[\begin{array}{l} p+q+r=s=\Sigma Wi=a \\ \alpha^3 p+\alpha^2 q+\alpha r+S=\Sigma\alpha^i Wi=b \\ \alpha^6 p+\alpha^4 q+\alpha^2 r+s=\Sigma\alpha^{2i}Wi=c \\ \alpha^9 p+\alpha^6 q+\alpha^3 r+s=\Sigma\alpha^{3i}Wi=d \end{array}\right.$$

Omitting the calculation process, the result is as follows:

$$\left[\begin{array}{c} p \\ q \\ r \\ s \end{array}\right] = \left[\begin{array}{cccc} \alpha^{212} & \alpha^{153} & \alpha^{152} & \alpha^{209} \\ \alpha^{156} & \alpha^{2} & \alpha^{135} & \alpha^{152} \\ \alpha^{158} & \alpha^{138} & \alpha^{2} & \alpha^{153} \\ \alpha^{218} & \alpha^{158} & \alpha^{156} & \alpha^{212} \end{array}\right] \left[\begin{array}{c} a \\ b \\ c \\ d \end{array}\right]$$

The role of the encoder provided at the transmitter is to generate the check words p, q, r and s as seen above.

Next, the fundamental algorithm when the data containing the check words thus formed is transmitted and received will be described below.

(1) For no error: $S_0=S_1=S_2=S_3=0$

(2) For one word error (where the error pattern is represented as $e_i$); $S_0=e_i$, $S_1=\alpha^i e_i$, $S_2=\alpha^{2i}e_i$ and $S_3=\alpha^{3i}e_i$, thus:

$$\left[\begin{array}{l} \alpha^i S_0=S_1 \\ \alpha^i S_1=S_2 \\ \alpha^i S_2=S_3 \end{array}\right.$$

Accordingly, when i is sequentially changed, whether or not the above relations are satisfied indicates whether the error is a one word error or not. Or:

$$\frac{S_1}{S_0} = \frac{S_2}{S_1} = \frac{S_3}{S_2} = \alpha^i$$

is established. Therefore, comparing the pattern of $\alpha^i$ with that previously memorized in a read-only memory (ROM), the error location i is known, so the syndrome $S_0$ at that time becomes the error pattern $e_i$ per se.

(3) For two word errors $e_i$ and $e_j$:

$$\left[\begin{array}{l} S_0=e_i+e_j \\ S_1=\alpha^i e_i+\alpha^j e_j \\ S_2=\alpha^{2i}e_i+\alpha^{2j}e_j \\ S_3=\alpha^{3i}e_i+\alpha^{3j}e_j \end{array}\right.$$

Modifying the above equations:

$$\left[\begin{array}{l} \alpha^j S_0+S_1=(\alpha^i+\alpha^j)e_i \\ \alpha^j S_1+S_2=\alpha^i(\alpha^i+\alpha^j)e_i \\ \alpha^j S_2+S_3=\alpha^{2i}(\alpha^i+\alpha^j)e_i \end{array}\right.$$

Therefore, if the following equations are established, an error is judged as two word errors and the error locations i and j are known:

$$\left[\begin{array}{l} \alpha^i(\alpha^j S_0 + S_1) = \alpha^j S_1 + S_2 \\ \alpha^i(\alpha^j S_1 + S_2) = \alpha^j S_2 + S_3 \end{array}\right.$$

In other words, the combinations of the error locations i and j are varied to check whether the relations between the above equations are satisfied or not. The error patterns $e_i$ and $e_j$ at that time are given as:

$$e_i = \frac{S_0 + \alpha^{-j} S_1}{1 + \alpha^{i-j}} \qquad e_j = \frac{S_0 + \alpha^{-i} S_1}{1 + \alpha^{j-i}}$$

(4) For three word errors $e_i$, $e_j$ and $e_k$:

$$\left[\begin{array}{l} S_0 = e_i + e_j + e_k \\ S_1 = \alpha^i e_i + \alpha^j e_j + \alpha^k e_k \\ S_2 = \alpha^{2i} e_i + \alpha^{2j} e_j + \alpha^{2k} e_k \\ S_3 = \alpha^{3i} e_i + \alpha^{3j} e_j + \alpha^{3k} e_k \end{array}\right.$$

Modifying the above equations:

$$\left[\begin{array}{l} \alpha^k S_0 + S_1 = (\alpha^i + \alpha^k) e_i + (\alpha^j + \alpha^k) e_j \\ \alpha^k S_1 + S_2 = \alpha^i(\alpha^i + \alpha^k) e_i + \alpha^j(\alpha^j + \alpha^k) e_j \\ \alpha^k S_2 + S_3 = \alpha^{2i}(\alpha^i + \alpha^k) e_i + \alpha^{2j}(\alpha^j + \alpha^k) e_j \end{array}\right.$$

thus:

$$\left[\begin{array}{l} \alpha^j(\alpha^k S_0 + S_1) + (\alpha^k S_1 + S_2) = (\alpha^i + \alpha^j)(\alpha^i + \alpha^k) e_i \\ \alpha^j(\alpha^k S_1 + S_2) + (\alpha^k S_2 + S_3) = \alpha^i(\alpha^i + \alpha^j)(\alpha^i + \alpha^k) e_i \end{array}\right.$$

from the above equations, if:

$$\alpha^i(\alpha^j(\alpha^k S_0 + S_1) + (\alpha^k S_1 + S_2)) = \alpha^j(\alpha^k S_1 + S_2) + (\alpha^k S_2 + S_3)$$

is established, an error can be judged as three word errors, where it is a necessary condition that $S_0 = 0$, $S_1 = 0$ and $S_2 = 0$ are all satisfied. The respective error patterns $e_i$, $e_j$ and $e_k$ at that time are obtained as follows:

$$\left[\begin{array}{l} e_i = \dfrac{S_0 + (\alpha^{-j} + \alpha^{-k}) S_1 + \alpha^{-j-k} S_2}{(1 + \alpha^{i-j})(1 + \alpha^{i-k})} \\[3ex] e_j = \dfrac{S_0 + (\alpha^{-k} + \alpha^{-i}) S_1 + \alpha^{-k-i} S_2}{(1 + \alpha^{j-i})(1 + \alpha^{j-k})} \\[3ex] e_k = \dfrac{S_0 + (\alpha^{-i} + \alpha^{-j}) S_1 + \alpha^{-i-j} S_2}{(1 + \alpha^{k-i})(1 + \alpha^{k-j})} \end{array}\right.$$

In practice, the construction required for the correction of three word errors is complex and the time period required for the correction operation is rather long. Accordingly, the above calculations are combined with the case where the error locations i, j and k are known and indicated by pointers, and the above equations are employed for check use at that time so as to perform the error correcting operation.

(5) For four word errors $e_i$, $e_j$, $e_k$ and $e_l$:

$$\begin{cases} S_0 = e_i + e_j + e_k + e_l \\ S_1 = \alpha^i e_i + \alpha^j e_j + \alpha^k e_k + \alpha^l e_l \\ S_2 = \alpha^{2i} e_i + \alpha^{2j} e_j + \alpha^{2k} e_k + \alpha^{2l} e_l \\ S_3 = \alpha^{3i} e_i + \alpha^{3j} e_j + \alpha^{3k} e_k + \alpha^{3l} e_l \end{cases}$$

Modifying the above equations:

$$\begin{cases} e_i = \dfrac{S_0 + (\alpha^{-j} + \alpha^{-k} + \alpha^{-l})S_1 + (\alpha^{-j-k} + \alpha^{-k-l} + \alpha^{-l-j})S_2 + \alpha^{-j-k-l}S_3}{(1 + \alpha^{i-j})(1 + \alpha^{i-k})(1 + \alpha^{i-l})} \\[2mm] e_j = \dfrac{S_0 + (\alpha^{-k} + \alpha^{-l} + \alpha^{-i})S_1 + (\alpha^{-k-l} + \alpha^{-l-i} + \alpha^{-i-k})S_2 + \alpha^{-k-l-i}S_3}{(1 + \alpha^{j-i})(1 + \alpha^{j-k})(1 + \alpha^{j-l})} \\[2mm] e_k = \dfrac{S_0 + (\alpha^{-l} + \alpha^{-i} + \alpha^{-j})S_1 + (\alpha^{-l-i} + \alpha^{-i-j} + \alpha^{-j-l})S_2 + \alpha^{-l-i-j}S_3}{(1 + \alpha^{k-i})(1 + \alpha^{k-j})(1 + \alpha^{k-l})} \\[2mm] e_l = \dfrac{S_0 + (\alpha^{-i} + \alpha^{-j} + \alpha^{-k})S_1 + (\alpha^{-i-j} + \alpha^{-j-k} + \alpha^{-k-i})S_2 + \alpha^{-i-j-k}S_3}{(1 + \alpha^{l-i})(1 + \alpha^{l-j})(1 + \alpha^{l-k})} \end{cases}$$

Thus, if the error locations, i, j, k and l are made clear by the pointers, the error correction is possible using the above calculations.

The fundamental algorithm of the error correction as set forth above uses the syndrome $S_0$ to $S_3$ to check in the first step whether an error exists, to check in the second step whether or not the error is a one word error, and to check in the third step whether or not the error is a two-word error. To correct up to two word errors, the time period required to complete all the steps is extended. This problem of the extended time period arises particularly when the error locations of two word errors are searched. Therefore, a modified algorithm which alleviates this problem and is effective when applied to the case where the correction of two word errors is involved will now be described.

Equations for the syndromes $S_0$, $S_1$, $S_2$ and $S_3$ for two word errors are given similarly to the above as:

$$\begin{cases} S_0 = e_i + e_j \\ S_1 = \alpha^i e_i + \alpha^j e_j \\ S_2 = \alpha^{2i} e_i + \alpha^{2j} e_j \\ S_3 + \alpha^{3i} e_i + \alpha^{3j} e_j \end{cases}$$

Modifying these equations:

$$(\alpha^i S_0 + S_1)(\alpha^i S_2 + S_3) = (\alpha^i S_1 + S_2)^2$$

Further modifying the above equation, the following error location polynomial is obtained:

$$(S_0 S_2 + S_1{}^2)\alpha^{2i} + (S_1 S_2 + S_0 S_3)\alpha^i + (S_1 S_3 + S_2{}^2) = 0$$

where coefficients of the respective equations are assumed by:

$$\begin{cases} S_0 S_2 + S_1{}^2 = A \\ S_1 S_2 + S_0 S_3 = B \\ S_1 S_3 + S_2{}^2 = C \end{cases}$$

Accordingly, by the use of the respective coefficients A, B and C of the above equations, it is possible to obtain the error locations for two word errors.

(1) For no error: $A=B=C=0$, $S_0=0$, and $S_3=0$.

(2) For one word error: When $A=B=C=0$, $S_0\neq0$, and $S_3\neq0$ are established, the error is judged as one word error. The error location i is known from $\alpha^i=S_1/S_0$ and $e_i=S_0$ is employed to correct the error.

(3) For two word errors: For more than two word errors, $A\neq0$, $B\neq0$ and $C\neq0$ are established and hence the judgement thereof becomes very simple. At this time:

$$Aa^{2i}+Ba^i+C=0$$

(where $i=0$ to $(n-1)$ is established. Let us assume that $B/A=D$ and $C/A=E$ are established:

Then:

$$D=a^i+a^j \text{ and } E=a^i . a^j$$

Thus:

$$a^{2i}+Da^i+E=0$$

here, let the difference between two error locations be t or $j=i+t$. Then, the above equations are modified as follows:

$$D=a^i(1+a^t) \text{ and } E=a^{2i+t}$$

Thus:

$$\frac{D^2}{E} = \frac{(1+a^t)^2}{t}=a^{-t}+a^t$$

Accordingly, if the ROM is previously written with values of $(a^{-t}+a^t)$ relating to the respective ($t=1$ to $(n-1)$) and it is detected that the output of the ROM is coincident with values of $(D^2/E)$ calculated from the received words, then t is obtained. If this coincidence relation therebetween is not established, the error is regarded as more than three word errors.

Therefore, let us assume that:

$$X=1+a^t$$

$$Y+1+a^{-t}=\frac{D^2}{E}+X$$

Then:

$$a^i=\frac{D}{X}, \qquad a^j=\frac{D}{Y}$$

thus the error locations i and j are obtained. Also, the error patterns $e_i$ and $e_j$ are obtained as follows:

$$e_i=\frac{-(a^jS_0+S_1)}{D}=\frac{S_0}{Y}+\frac{S_1}{D}$$

$$e_j=\frac{(a^iS_0+S_1)}{D}=\frac{S_0}{X}+\frac{S_1}{D}$$

so, the error correction is possible.

In the error correction of up to two word errors, the modified correcting algorithm as set forth above is capable of substantially reducing the time period required to obtain the error location as compared with the fundamental algorithm.

If the number k of the check words is increased, the error correcting ability is improved still more. For example, let the number k of the check words be six. Then up to three word errors can be corrected, and further, when the error locations are known, up to six word errors can be corrected.

In the above error correction, when one word error is to be corrected, there remain first and second possibilities. The first possibility is that errors of more than four words are detected as a one word error and then corrected, while the second possibility is that errors of more than three words are detected as two word errors and then corrected. In this case, although the latter probability is greater than the former, neither of the first and second possibilities is particularly small.

A practical example in which the invention is applied to the recording and reproduction of an audio PCM signal will now be described with reference to the accompanying drawings.

8

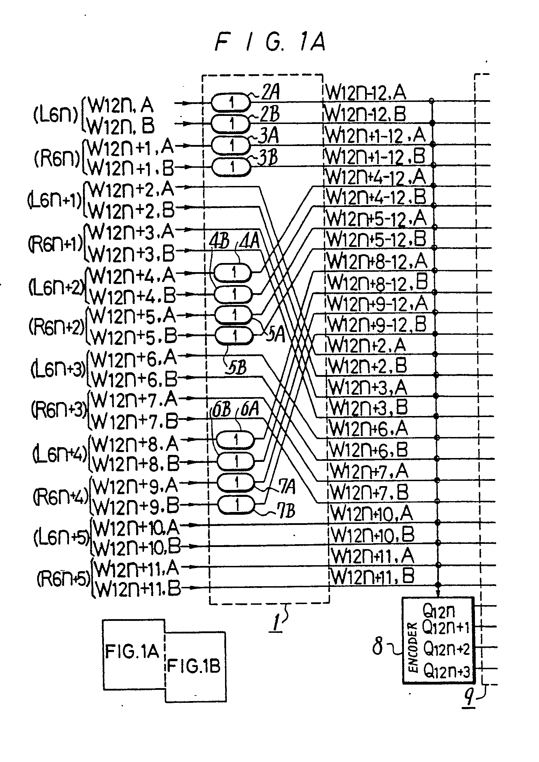

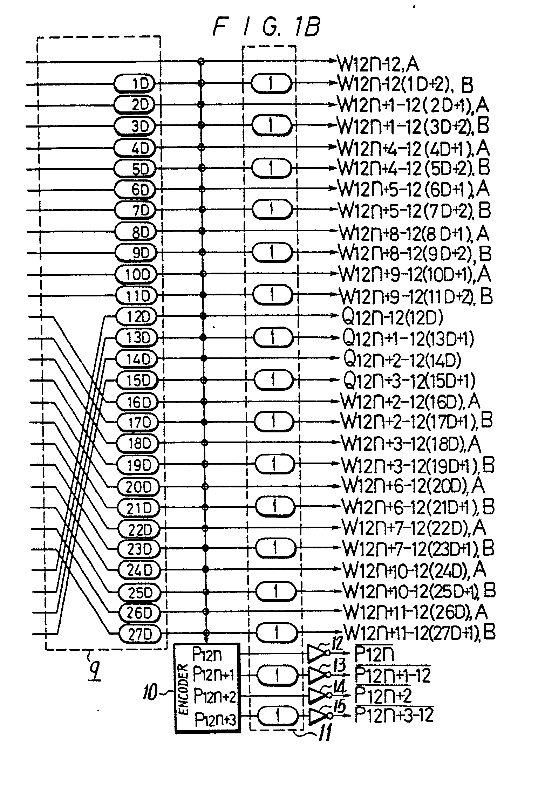

Figure 1 schematically shows an overall arrangement of an error correcting encoder provided at the recording side, which is supplied at its input with the audio PCM signal. Figure 1 is divided into Figures 1A and 1B to be accommodated on the sheets. The audio PCM signal is derived by sampling each of respective right and left stereophonic signals at a sampling frequency $f_s$ (for example, 44.1 kHz) and then converting each sample to one word (using a code of 2's complement formed of sixteen bits). Accordingly, as regards the audio signal of the left channel, there appears PCM data in which respective words are successively $L_0$, $L_1$, $L_2$, ..., while as regards the audio signal of the right channel, there appears PCM data in which respective words are successively $R_0$, $R_1$, $R_2$, .... The PCM data of the right and left channels are respectively distributed into six channels, so the PCM data sequences of totally twelve channels are supplied to this error correcting encoder. At a predetermined timing, twelve words $L_{6n}$, $R_{6n}$, $L_{6n+1}$, $R_{6n+1}$, $L_{6n+2}$, $R_{6n+2}$, $L_{6n+3}$, $R_{6n+3}$, $L_{6n+4}$, $R_{6n+4}$, $L_{6n+5}$, $R_{6n+5}$ are supplied thereto. In this example, one word is separated into the upper (more significant) eight bits and the lower (less significant) eight bits, respectively, and twelve channels are further divided into twenty-four channels and then processed. In brief, one word of PCM data is represented as $W_i$, and the upper eight bits are discriminated by adding suffix A as in $W_{i,A}$, while the lower eight bits are also discriminated by adding suffix B as in $W_{i,B}$. For example, the left channel word $L_{6n}$ is divided into $W_{12n,A}$ and $W_{12n,B}$.

The PCM data sequences of twenty-four channels are first supplied to an even-odd interleaver 1. Let n be 0, 1, 2, .... Then each of $L_{6n}(=W_{12n,A}, W_{12n,B})$, $R_{6n}(=W_{12n+1,A}, W_{12n+1,B})$, $L_{6n+2}(=W_{12n+4,A}, W_{12n+4,B})$, $R_{6n+2}(=W_{12n+5,A}, W_{12n+5,B})$, $L_{6n+4}(=W_{12n+8,A}, W_{12n+8,B})$, $R_{6n+4}(=W_{12n+9,A}, W_{12n+9,B})$ is an even-numbered word, and words other than these are odd-numbered words. The respective PCM data sequences comprising even-numbered words are delayed by one word by one-word delay circuits 2A, 2B, 3A, 3B, 4A, 4B, 5A, 5B, 6A, 6B and 7A, 7B in the even-odd interleaver 1. Of course, they may be delayed by more words than one word, for example, eight words. Also, the even-odd interleaver 1 converts the PCM data sequences in such a manner that twelve data sequences formed of even-numbered words share 1st to 12th transmission channels, and the other twelve data sequences formed of odd-numbered words share 13th to 24th transmission channels.

The even-odd interleaver 1 serves to prevent each of the right and left stereophonic signals from being erroneous in more than two successive words and in addition, prevents this error from being uncorrectable. By way of example, consider three successive words of $L_{i-1}$, $L_i$, and $L_{i+1}$. When $L_i$ is erroneous and uncorrectable, either $L_{i-1}$ or $L_{i+1}$ is desired to be correct. This is chiefly because when the erroneous data $L_i$ is corrected, the data $L_i$ is interpolated by the preceding data $L_{i-1}$ (held by the previous value) or by the mean value between the data $L_{i-1}$ and $L_{i+1}$. The delay circuits 2A, 2B to 7A, 7B of the even-odd interleaver are provided so as to make the adjacent words be contained in different error correcting blocks. Also, the reason why the transmission channels are grouped into data sequences, each formed of even-numbered words and odd-numbered words is that upon interleaving, the distance between the recording positions of the adjacent even-numbered and odd-numbered words has to be as large as possible.

At the output of the even-odd interleaver 1 appear the PCM data sequences of twenty-four channels, each of which is in the first arrangement state, from which the PCM data sequences are derived word by word and then supplied to a first encoder 8, which forms first check words $Q_{12n}$, $Q_{12n+1}$, $Q_{12n+2}$, $Q_{12n+3}$. The first error correcting blocks including the above first check words are constructed as follows:

$$(W_{12n-12,A},\ W_{12n-12,B},\ W_{12n+1-12,A},\ W_{12n+1-12,B},$$

$$W_{12n+4-12,A},\ W_{12n+4-12,B},\ W_{12n+5-12,B},\ W_{12n+5-12,B},$$

$$W_{12n+8-12,A},\ W_{12n+8-12,B},\ W_{12n+9-12,A},\ W_{12n+9-12,B},$$

$$W_{12n+2,A},\ W_{12n+2,B},\ W_{12n+3,A},\ W_{12n+3,B},$$

$$W_{12n+6,A},\ W_{12n+6,B},\ W_{12n+7,A},\ W_{12n+7,B},$$

$$W_{12n+10,A},\ W_{12n+10,B},\ W_{12n+11,A},\ W_{12n+11,B},$$

$$Q_{12n},\ Q_{12n+1},\ Q_{12n+2},\ Q_{12n+3})$$

The first encoder 8 encodes the word number of one block: (n=28), the bit number of one word: (m=8), and the number of check words: (k=4).

The twenty-four PCM data sequences and the four check word sequences are supplied to an interleaver 9. In the interleaver 9, delays for interleave operation are carried out after the positions of the transmission channels are varied so as to interpose the check word sequences between the PCM data sequences formed of even-numbered words and odd-numbered words. This delay process is implemented by inserting delay circuits having delay times of 1D, 2D, 3D, 4D, ..., 26D, 27D (where D represents a unit delay time of, for example, four words) into twenty-seven transmission channels, respectively, other than the first transmission channel.

9

Therefore, the interleaver 9 produces at its output twenty-eight data sequences, each of which is in the second arrangement state, from which each one word is derived and then supplied to a second encoder 10 to form second check words $P_{12n}$, $P_{12n+1}$, $P_{12n+2}$ and $P_{12n+3}$. A second error correcting block including the above second check words and comprising thirty-two words is as follows:

$$(W_{12n-12,A}, \ W_{12n-12(D+1),B}, \ W_{12n+1-12(2D+1),A},$$

$$W_{12n+1-12(3D+1),B}, \ W_{12n+4-12(4D+1),A},$$

$$W_{12n+4-12(5D+1),B}, \ W_{12n+5-12(6D+1),A},$$

$$W_{12n+5-12(7D+1),B},$$

$$\cdots\cdots$$

$$Q_{12n-12(12D)}, \ Q_{12n+1-12(13D)}, \ Q_{12n+2-12(14D)},$$

$$Q_{12n+3-12(15D)}$$

$$\cdots\cdots$$

$$W_{12n+10-12(24D),A}, \ W_{12n+10-12(25D),B},$$

$$W_{12n+11-12(26D),A}, \ W_{12n+11-12(27D),B},$$

$$P_{12n}, \ P_{12n+1}, \ P_{12n+2}, \ P_{12n+3})$$

There is provided an interleaver 11 in which delay circuits each having one word delay amount are provided for the even-numbered transmission channels in thirty-two data sequences including such first and second check words, and inverters 12, 13, 14 and 15 are provided for the second check word sequences. The interleaver 11 so acts that the errors across the border between the error correcting blocks may be prevented from easily becoming an uncorrectable number of words. Whereas, the inverters 12 to 15 are provided to avoid a misoperation in which all data within one block are turned to "0" by drop-out upon transmission of data, and these data are verified as correct in the reproducing system. With the same purpose as described above, inverters may be inserted for the first check word sequences.

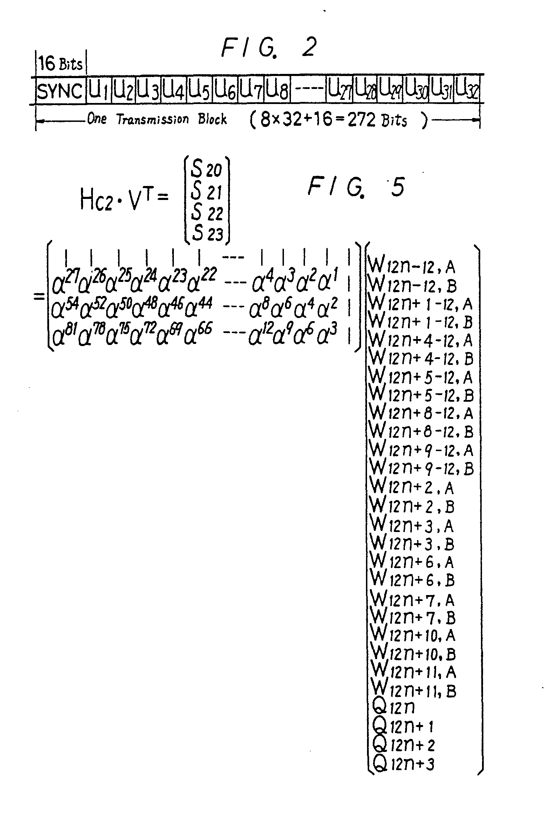

The data derived from twenty-four PCM data sequences and eight check word sequences are respectively arranged in series at every thirty-two words, and then had added at its beginning a synchronizing signal SYNC of sixteen bits so as to form one transmission block as shown in Figure 2, which is then transmitted. In Figure 2, for the sake of simplicity, one word derived from the i*th* transmission channel is indicated as $u_i$. Practical examples of the transmission system are a magnetic recording/reproducing apparatus or a rotary disc.

The encoder 8 is for the error correcting codes as mentioned before, where n=28, m=8, and k=4, while the like encoder 10 is also for the error correcting codes, where n=32, m=8, and k=4.

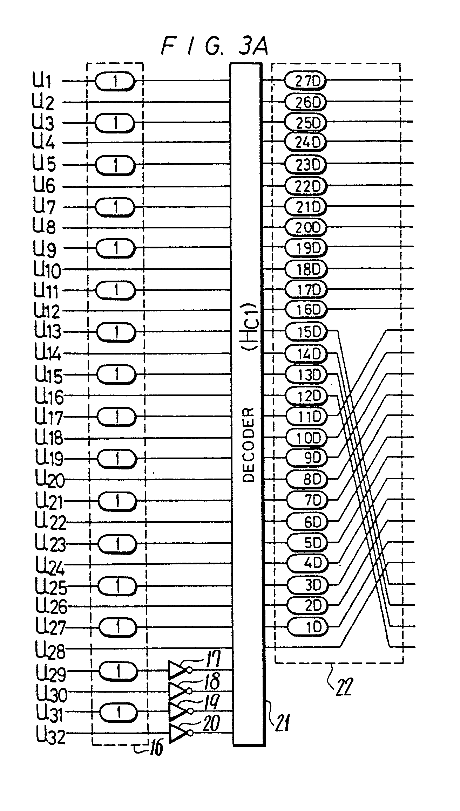

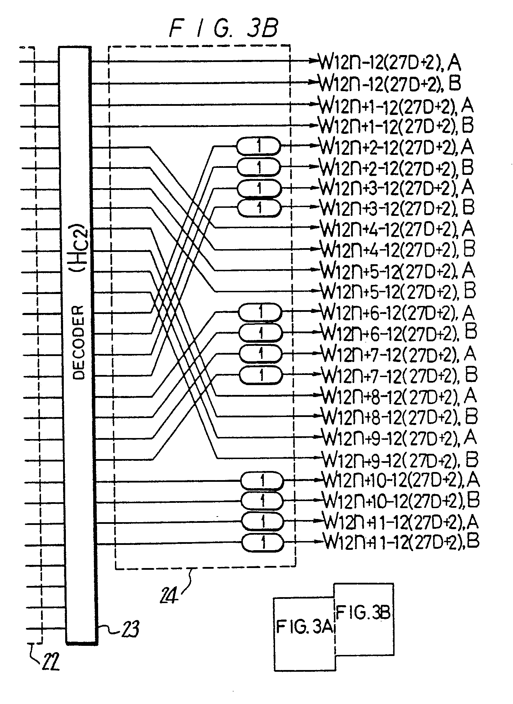

The reproduced data are supplied at every thirty-two words of one transmission block to inputs of an error correcting decoder shown in Figure 3 (Figure 3 is likewise divided into Figures 3A and 3B to fit on the sheets). Because of the reproduced data, there is a possibility that they will contain errors. If no error exists, thirty-two words supplied to this error correcting decoder are coincident with thirty-two words appearing at the output of the error correcting encoder. The error correcting decoder performs the deinterleave, which corresponds to the interleave done by the error correcting encoder, so as to recover the data to the original arrangement state and then to allow the error to be corrected.

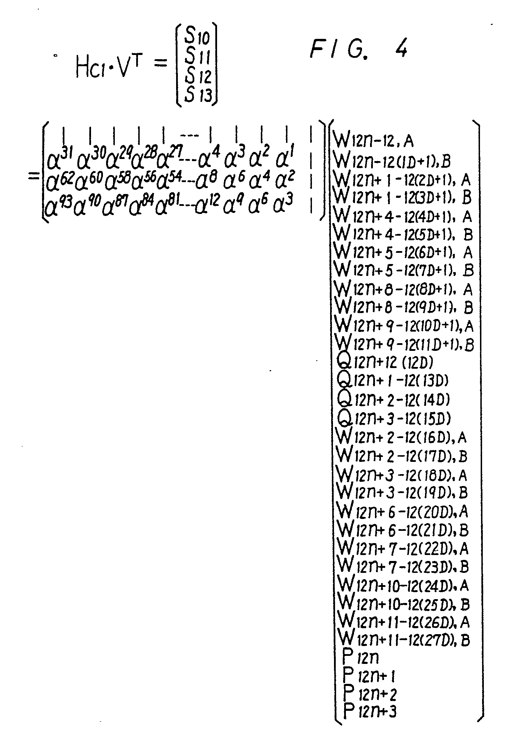

A de-interleaver 16 into which one word delay circuits are inserted is provided in the error correcting decoder for the odd-numbered transmission channels, while inverters 17, 18, 19 and 20 are provided for the check word sequences to allow the data sequences and the check word sequences to be supplied to a decoder 21 of the first stage. As shown in Figure 4, the decoder 21 produces syndromes $S_{10}$, $S_{11}$, $S_{12}$ and $S_{13}$ from parity check matrix $H_{c1}$ and thirty-two words ($V^T$) applied so as to carry out the error correction based upon the above syndromes $S_{10}$, $S_{11}$, $S_{12}$ and $S_{13}$, where $a$ represents an element of $GF(2^8)$ expressed as $F(x)=x^8+x^4+x^3+x^2+1$. The decoder 21 produces twenty-four PCM data sequences and four check word sequences, where each of the data sequences has added at every one word a pointer of at least one bit indicating the presence or absence of an error (if an error exists the pointer is "1", and if not, "0").

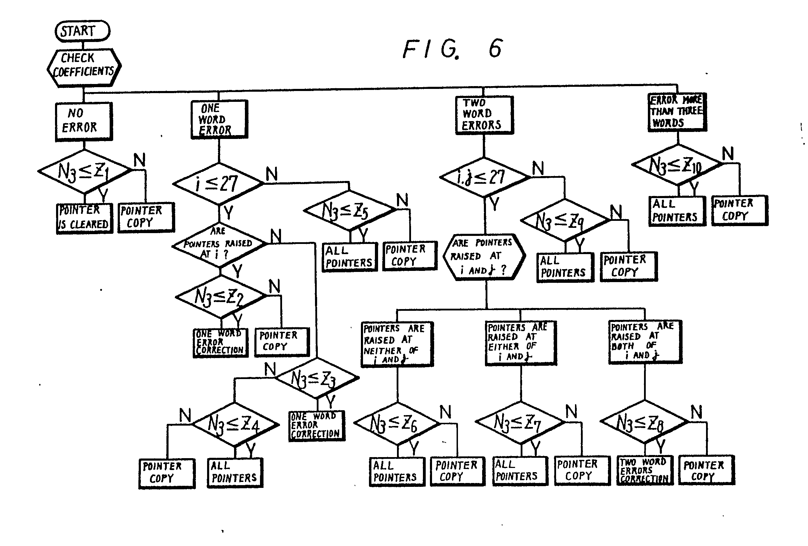

In Figures 4 and 5, which will be described later, as well as the following description, the received one word $W_i$ is simply expressed as $W_i$.

The output data sequences from the decoder 21 are supplied to a de-interleaver 22. The de-interleaver 22 serves to cancel the delays due to the interleaver 9 in the error correcting encoder, in which the respective transmission channels from the 1st to the 27th are provided with delay circuits having different delay times such as 27D, 26D, 25D, ..., 2D, 1D. The outputs of the de-interleaver 22 are supplied to a decoder 23. In the decoder 23, as shown in Figure 5, syndromes $S_{20}$, $S_{21}$, $S_{22}$ and $S_{23}$ are generated by a parity check matrix $H_{c2}$ and twenty-eight words $V^T$ applied thereto, and the error correction is performed on the basis of the parity check matrix $H_{c2}$ and twenty-eight words $V^T$.

The data sequences appearing at the output of the decoder 23 at the next stage are supplied to an even-odd de-interleaver 24. In the even-odd de-interleaver 24, the PCM data sequences formed of even-numbered words, and the PCM data sequences formed of odd-numbered words are rearranged to form alternating transmission channels, and one word delay circuits are provided for the PCM data sequences formed of odd-numbered words. Accordingly, the even-odd de-interleaver 24 produces at its output the PCM data sequences having the same arrangement states and the transmission channels of the predetermined orders as those supplied to the error correcting encoder. Although not shown in Figure 3, the even-odd de-interleaver 24 is followed by a correcting or interpolating circuit, in which interpolation, for example, a mean value interpolation to conceal an error which is uncorrectable by the decoders 21 and 23, is performed.

In one example, the decoder 21 at the first stage corrects one word errors and two word errors, and detects errors of more than three words. At the same time, words to be corrected and detected have pointers added of three kinds which show the presence of errors and are different from one another. Taking the 2-bit pointer as an example, when one word error is corrected, all of thirty-two words or all of twenty-eight words other than the four check words within the error correcting block have added a pointer (01). When two word errors are corrected, the respective words have added a pointer (10), while when errors of more than three words are detected, a pointer (11) is added thereto. Of course, when no error is detected, the pointer becomes (00).

Also, a pointer of three bits may be employed. In this case, when no error is detected, a pointer pattern of (000) is used; when one word error is corrected, (001); when two word errors are corrected, (010); and when errors of more than three words are detected, (100).

These pointers are added to respective words, processed by the de-interleaver 22 and then supplied to the decoder 23 at the following stage. As will be mentioned later, in the error correction at the next stage of the decoder 23, the pointers are added thereto or cleared, while in the interpolating or correcting circuit, based upon the finally remaining pointers the correcting operation is performed.

The decoder 23 at the next stage utilizes the number of the error words indicated by the aforesaid pointers or the error locations to carry out the error correction.

Figure 6 shows one example of the error correction done by the decoder 23 at the next stage. In Figure 6 and subsequent explanations, the number of error words indicated by the first pointer in the correction of one word error is represented by $N_1$; the number of error words indicated by the second pointer added in the correction of two word errors is represented by $N_2$; and the number of error words indicated by the third pointer added in the detection of errors of more than three words is represented by $N_3$. Also in Figure 6, character Y indicates affirmative or yes, while character N indicates negative or no. Since the decoder 23 at the next stage corrects up to two word errors, it is preferable to use the modified algorithm for the error correction algorithm. In other words, at the beginning of the flow chart shown in Figure 6, the foregoing error location polynomial $(A^{2l}+B^l+C=0)$ is calculated to allow the error correction to be performed using these coefficients A, B, C and the syndromes $S_{20}$ to $S_{23}$. At the same time, each of the total numbers $N_1$, $N_2$ and $N_3$ of the first, second and third pointers contained in one block is counted. In this case, of course, it may be possible to employ the fundamental algorithm, in which by the use of the syndromes, the detection of the absence of error, the detections of a one word error, and the detection of two word errors are carried out step by step.

(1) Check the presence or absence of error. When $A=B=C=0$, $S_{20}=0$, and $S_{23}=0$ are satisfied, the absence of error is recognized for the time being. In this case, it is checked that $N_3$ is less than or equals to $z_1$. If this is satisfied, it is judged that there is no error and the pointer within the error correcting block is cleared. If $N_3$ is greater than $z_1$, the detection of error done by the syndromes is judged as incorrect and hence the pointers are left as they are. In pointer copying, it is also possible that only the third pointer added on the detection of errors of more than three words and possibly, in addition, the second pointer added in the correction of two word errors are intended to be copied. To be more definite, the probability of the correction of one word error being erroneous is so small that the first pointer may be left out of the pointer copying operation. The value of $z_1$ is large and is in a range from about ten to fourteen.

(2) Check whether the error is a one word error or not. When $A=B=C=0$, $S_{20}\neq0$, and $S_{23}\neq0$ are satisfied, the error is judged to be one word error for the time being and hence the error location i is searched from $S_{21}/S_{20}=a^i$. Whether or not the error location i is included in a range from 0 to 27 is detected. If the error location i is out of the above range, the correction of one word error is impossible. Then, whether $N_3$ is less than or equal to $z_5$ is satisfied or not is judged, in which the value of this $z_5$ is given as 3 or 5. When this condition is established, for the erroneous detection of one word error, the number of pointers is so small that all the words included within the error correcting block have the third pointer added. When $N_3$ is greater than $z_5$, the pointer copying operation is carried out similarly to the above.

Next, whether or not an error pointer is present at this error location i is detected. In this case, the pointers added in the correction of two word errors and the pointers added in the detection of errors of more than three words must be judged. If the pointer is present at the error location i, then whether or not

$N_3$ is less than or equal to $z_2$ is checked. In this case, the value of $z_2$ is given as, for example, ten. If $N_3$ is less than or equal to $z_2$ is established, the error is judged as one word error to allow the error correction to be carried out by the use of $e_i = S_{20}$. Even when the pointer is present at the error location i, if $N_3$ is greater than $z_2$, for the one word error the number of pointers is too great, so it is dangerous to judge the error as a one word error, and the pointers are left as they are (pointer copying operation).

When the second and third pointers are not present at the error location i, whether or not $N_3$ is less than or equal to $z_3$ is checked. Even when the first pointer is raised at the error location i, this is checked. In this case, the value of $z_3$ is a fairly small number, for example, three. When $N_3$ is less than or equal to $z_3$ is satisfied, by the calculation of the syndromes, one word error at the error location i is corrected.

When $N_3$ is greater than $z_3$, whether or not $N_3$ is less than or equal to $z_4$ is also checked. In other words, when $z_3$ is less than $N_3$ is less than or equal to $z_4$ is satisfied, this means that for the erroneous judgement of one word error by the syndromes, $N_3$ is too small, so pointers are added to all words within the error correcting block. On the contrary, when $N_3$ is greater than $z_4$, the pointers remain as they are.

When to judge whether or not $N_3$ is less than or equal to $z_2$ is established, the number $N_2$ of the second pointer may be taken into consideration. By way of example, the number $N_2$ of the second pointer is weighted less than the number $N_3$ of the third pointer and then the total numbers of both of them are compared with each other.

(3) Check whether the errors are two word errors or not. If they are two word errors, the error locations i and j are detected by the calculations. When $A \neq 0$, $B \neq 0$, and $C \neq 0$ are established and $D^2/E = a^{-t} + a^t$ are also established where t ranges from one to twenty-seven, the error is judged as two word errors and hence the error locations i and j are searched by $a^i = D/X$ and $a^j = D/Y$. Then, whether the error locations i and j both belong together to the range from zero to twenty-seven or not is detected. When the error locations i and j are out of the above range together, the correction of two word errors is impossible.

Then, the establishment of $N_3$ is less than or equal to $z_9$ is judged, where the value of this $z_9$ is given as about two or three. When the above condition is satisfied, for the erroneous detection of two word errors, the number of the pointers is so small that all the words included within the error correcting block have the third pointer added. When $N_3$ is greater than $z_9$, the pointer copying operation is performed similarly to the above.

Moreover, when the error locations i and j are both to be within the range from zero to twenty-seven, whether or not the third pointer is present in these is checked. In this case, the probability that the detection of two word errors is erroneous per se is higher than that of the detection of one word error, so that only the third pointer must be judged. When the pointer is raised in neither of the error locations i and j, whether or not $N_3$ is less than or equal to $z_6$ is checked, where the value of $z_6$ is, for example, two. When this condition is satisfied, as the pointers are present in neither of the error locations i and j, the number of pointers is so small that all the words within the error correcting block have the third pointer added. Also, when $N_3$ is greater than $z_6$, the pointer copying operation is carried out.

When the error pointer is present at either of the error locations i and j, whether or not $N_3$ is less than or equal to $z_7$ (where the value of $z_7$ is, for example, three) is checked. If the above condition is satisfied, all pointers are employed. If not, the pointer copying operation is carried out.

When the pointers are present at both of the error locations i and j, whether or not $N_3$ is less than or equal to $z_8$ (where the value of $z_8$ is, for example, four) is detected. If $N_3$ is less than or equal to $z_8$ is established, the error correction of two word errors with respect to the error locations i and j is performed. This correction is effected by searching the error patterns $e_i$ and $e_j$ as described before. When $N_3$ is greater than $z_8$, it is judged that there will be a larger probability of errors of more than three words being erroneously detected as two word errors, so the error correction is not performed but the pointer copying operation is performed.

(4) Belonging to neither of the above conditions (1), (2), and (3) or when errors exceeding two words exist, the error correction is not performed. Then, whether or not $N_3$ is less than or equal to $z_{10}$ is checked. If this is satisfied, reliability of the pointer is judged to be low so that all pointer operation is carried out. If $N_3$ is greater than $z_{10}$, then the pointers are left unchanged.

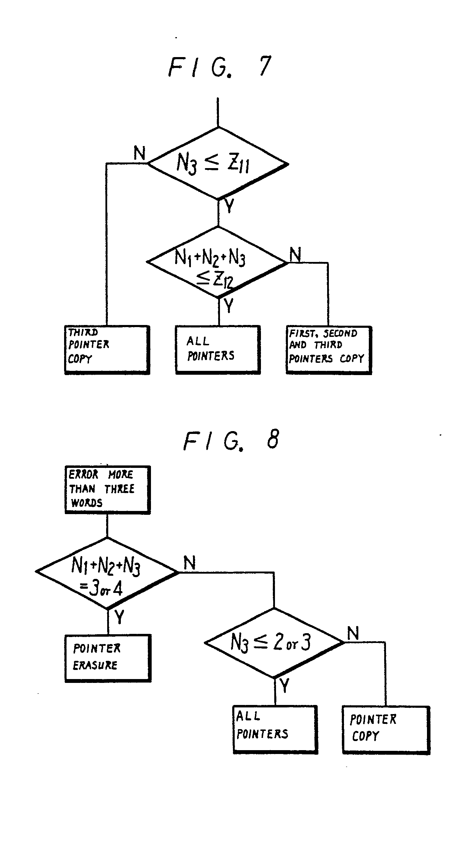

Figures 7 and 8 are flow charts each being used to explain a partial modification of the error correction at the next decoder.

While in Figure 6 there are utilized only two operations of all pointer and pointer copying, if the numbers of the first and second pointers are taken into consideration, finer processing is possible.

As shown in Figure 7, initially, with respect to the number $N_3$ of the third pointer, whether or not $N_3$ is less than or equal to $z_{11}$ is checked. When as in $N_3$ is greater than $z_{11}$ there are a number of error words, only the third pointer remains the same. Also, when $N_3$ is less than or equal to $z_{11}$ is established, the establishment of $N_1 + N_2 + N_3$ is less than or equal to $z_{12}$ is checked, where while the value of $z_{11}$ is given as about four, the value of $z_{12}$ is large such as about ten. When the above relation or condition is satisfied, it is judged that the pointer is low in reliability, so all the words contained in the error correcting block have the third pointer added. When $N_1 + N_2 + N_3$ is greater than $z_{12}$ is established, the reliability of the pointer is judged as high, so that the first, second and third pointers all remain the same.

When errors of more than three words are detected, using the error locations i, j and k or i, j, k and l indicated by the pointers, a pointer erasure operation may be available for the correction of three word errors or four word errors. Figure 8 shows a flow chart of this case. When the error is jduged as an error of

12

more than three words, whether or not the sum of the number of the first, second and third pointers is three or four is checked. When $N_1+N_2+N_3$ equal three (or four) is established, the error locations i, j, k and l indicated by these pointers are used to search for the error patterns. Unless the condition or relation of the above equation is satisfied, whether or not the number $N_3$ of the third pointer is less than two (or three) is checked. When $N_3$ is less than or equal to two (or three) for the error of three words or more, the number of pointers is so small that the reliability of the pointer is judged to be low, so all the words have pointers added. When $N_3$ is greater than two or three, the second and third pointers or the third pointer remains the same. As described above, in the pointer erasure operation, by the use of the first pointer, it is possible to reduce the probabilities of erroneous correction and uncorrectability.

In the error correcting decoder shown in Figure 3 as mentioned above, the error correction using the first check words $Q_{12n}$, $Q_{12n+1}$, $Q_{12n+2}$ and $Q_{12n+3}$ and the error correction using the second check words $P_{12n}$, $P_{12n+1}$, $P_{12n+2}$ and $P_{12n+3}$ are respectively carried out once. If the respective error corrections are performed more than twice (in practice, about twice), the result after correction where errors are further reduced can be used so that much more error correcting ability is possible. When the decoder is further provided at a later stage as described above, the decoders 21 and 23 are required to correct the check words.

Although in the above example, the interleaver 9 has delay times in its delay processing, each of which is different by the same amount D, it is possible for the change thereof to be irregular. Moreover, the second check word $P_i$ is the error correcting code comprising the PCM data as well as the first check word $Q_i$. Similarly, to the above, it is possible that the first check word $Q_i$ may contain the second check word $P_i$. In practice, it is sufficient to feed back the second check word $P_i$ to the encoder which generates the first check word. Such feed back is effective for a case where the decoding is performed more than three times as mentioned above.

As will be understood from the above description, a burst error is dispersed by the cross-interleave technique so that random and burst errors can be corrected effectively. Moreover, when decoding operations in more than two stages are carried out, if pointers of more than one kind are added in the first stage and such pointers are used giving consideration to differences in reliability, it is possible to reduce the risk of erroneous correction or of uncorrectable errors.

While in the embodiment described, the error correcting code uses adjacent codes, it is possible to employ an error correcting code which can correct one word error and detect up to two word errors.

## Claims

1. A method of error correction of a pulse code modulated data sequence in which first and second error correcting blocks have been formed, each of said first error correcting blocks comprising a plurality of data words ($W_{12n-12,A}$ to $W_{12n+11,B}$) contained in said pulse code modulated data sequence and first check words ($Q_{12n}$ to $Q_{12n+3}$) generated therefrom and associated therewith, each of said second error correcting blocks having been derived by subjecting said words of each of said first error correcting blocks to respective different delays so as to interleave said words, and each of said second error correcting blocks comprising a plurality of data words ($W_{12n-12,A}$ to $W_{12n11-12(27D),B}$), each of which is included in a different one of said first error correcting blocks, and second check words ($P_{12n}$ to $P_{12n+3}$) generated therefrom and associated therewith, the method of error correction comprising the steps of:
first decoding said second error correcting blocks in a first stage (21);
said first decoding including the steps of:
detecting the error-status of said data words in said second error correcting blocks; and
adding a respective pointer to each erroneous said data word;
de-interleaving said data words to re-form said first error correcting blocks;
second decoding said first error correcting blocks in a second stage (23); and
processing said data words on the basis of said pointers so as to correct or compensate each said erroneous data word; characterized in that:
said first decoding includes the steps of detecting one of more than two types of error-status, such as no error, one-word error, two-word error, in said second error correcting blocks;
correcting at least said one-word errors; and
adding a respective pointer (N1, N2, N3) consisting of a plurality of bits and corresponding respectively to said types of error-status to each of data words so as to distinguish said error-status;
said second decoding includes the step of correcting further errors; and
said processing of said data words includes the subsequent step of discriminating the kind of said pointers and processing said data words on the basis of the result of said discrimination so as to correct each of said erroneous data words when the number of said erroneous data words is discriminated to be within the error correction capability and otherwise to compensate each of said erroneous data words.

2. A method according to claim 1 wherein the number of the more reliable pointers of said pointers being added in said first stage (21) and contained in one of said first error correcting blocks is determined during said decoding in said second stage (23) so as to judge whether or not error correction is possible.

3. A method according to claim 1 wherein when the error correction is impossible in said decoding in said second stage (23), in accordance with the degree of reliability of the pointers in the error correcting block used, pointers are added to all words contained in the common error correcting block or the pointers added during the decoding in said second stage (23) remain unchanged.

4. A method according to claim 1 wherein said second check words ($P_{12n}$ to $P_{12n3}$) in said second error correcting blocks are each generated from said data words ($W_{12n-12,A}$ to $W_{12n+11-12(27D),B}$) and said first check words ($Q_{12n}$ to $Q_{12n+3}$).

5. A method according to claim 1 wherein said first check words ($Q_{12n}$ to $Q_{12n+3}$) in said first error correcting blocks are each generated from said data words ($W_{12n-12,A}$ to $W_{12n+11,B}$) and said second check words ($P_{12n}$ to $P_{12n+3}$).

## Patentansprüche

1. Verfahren zur Fehlerkorrektur von Daten einer pulscodemodulierten Datenfolge, in der erste und zweite Fehlerkorrekturblöcke gebildet worden sind, wobei jeder der ersten Fehlerkorrekturblöcke aus mehreren Datenwörtern ($W_{12n-12,A}$ bis $W_{12n+11,B}$), die in der pulscodemodulierten Datenfolge enthalten sind, und ersten Prüfwörtern ($Q_{12n}$ bis $Q_{12n+3}$), die daraus erzeugt wurden und ihnen zugeorndet sind, besteht, wobei jeder der zweiten Fehlerkorrekturblöcke durch Unterwerfen der Wörter jedes der ersten Fehlerkorrekturblöcke jeweils unterschiedlichen Verzögerungen, um diese Wörter zu verschachteln, gewonnen worden ist und wobei jeder der zweiten Fehlerkorrekturblöcke aus mehreren von Datenwörtern ($W_{12-12,A}$ bis $W_{12n11-12(27D),B}$), wovon jedes in einem unterschiedlichen der ersten Korrekturblöcke enthalten ist, und zweiten Prüfwörtern ($P_{12n}$ bis $P_{12n+3}$), die daraus erzeugt wurden und ihnen zugeordnet sind, besteht, wobei das Verfahren zur Fehlerkorrektur folgende Schritte enthält:

— ein erste Decodieren der zweiten Fehlerkorrekturblöcke in einer ersten Stufe (21), wobei das erste Decodieren folgende Schritte enthält: Erfassen des Fehlerzustands der Datenwörter in den zweiten Fehlerkorrekturblöcken, Addieren einer entsprechenden Hinweismarke zu jedem fehlerhaften Datenwort, Entschachteln der Datenwörter, um die ersten Fehlerkorrekturblöcke neuzubilden,
— ein zweites Decodieren der ersten Fehlerkorrekturblöcke in einer zweiten Stufe (23) und
— ein Verarbeiten der Datenwörter auf der Grundlage der Hinweismarken, um so jedes der fehlerhaften Datenwörter zu korrigieren oder zu kompensieren,

dadurch gekennzeichnet, daß das erste Decodieren die Schritte enthält: Erfassen eines oder mehrerer Arten von Fehlerzuständen in den zweiten Fehlerkorrekturblöcken wie "Kein Fehler", "Ein-Wort-Fehler", "Zwei-Wort-Fehler", eine Korrektur zumindest der "Ein-Wort-Fehler" und ein Addieren einer entsprechenden Hinweismarke (N1, N2, N3), die aus mehreren Bits besteht und jeweils mit den Arten von Fehlerzuständen korrespondiert, zu jedem der Datenwörter, um so die Fehlerzustände zu unterscheiden, daß das zweite Decodieren den Schritt zum Korrigieren weiterer Fehler enthält und daß das Verarbeiten der Datenwörter den nachfolgenden Schritt zum Diskriminieren der Art der Hinweismarke und zum Verarbeiten der Datenwörter auf der Grundlage des Ergebnisses der Diskriminierung enthält, um so jedes der fehlerhaften Datenwörter zu korrigieren, wenn die Anzahl der fehlerhaften Datenwörter als innerhalb der Fehlerkorrekturfähigkeit liegend diskriminiert wurde, und um andernfalls jedes der fehlerhaften Datenwörter zu kompensieren.

2. Verfahren nach Anspruch 1, bei dem die Zahl der zuverlässigeren Hinweismarke, die in der ersten Stufe (21) addiert wird und in einem der ersten Fehlerkorrekturblöcke enthalten ist, während des Decodierens in der zweiten Stufe (2) bestimmt wird, um so zu beurteilen, ob eine Fehlerkorrektur möglich ist oder nicht.

3. Verfahren nach Anspruch 1, bei dem, wenn die Fehlerkorrektur bei dem Decodieren in der zweiten Stufe (23) in Übereinstimmung mit dem Grad der Zuverlässigkeit der Hinweismarken in dem verwendeten Fehlerkorrekturblock unmöglich ist, Hinweismarken zu allen Wörtern, die in dem gemeinsamen Fehlerkorrekturblock enthalten sind, addiert werden oder die Hinweismarken, die während des Decodierens in der zweiten Stufe (23) addiert wurden, unverändert bleiben.

4. Verfahren nach Anspruch 1, bei dem die zweiten Prüfwörter ($P_{12n}$ bis $P_{12n3}$) in den zweiten Fehlerkorrekturblöcken jeweils aus den Datenwörtern ($W_{12n-12,A}$ bis $W_{12n+11-12(27D),B}$) und den ersten Prüfwörtern ($Q_{12n}$ bis $Q_{12n+3}$) erzeugt werden.

5. Verfahren nach Anspruch 1, bei dem die ersten Prüfwörter ($Q_{12n}$ bis $Q_{12n+3}$) in den ersten Fehlerkorrekturblöcken jeweils aus den Datenwörtern ($W_{12n-12,A}$ bis $W_{12n+11,B}$) und den zweiten Prüfwörtern ($P_{12n}$ bis $P_{12n+3}$) erzeugt werden.

## Revendications

1. Procédé de correction d'erreurs d'une séquence de données modulées par impulsions codées, dans lequel des premiers et des seconds blocs de correction d'erreurs ont été formés, chacun desdits premiers blocs de correction d'erreurs, consistant en plusieurs mots de données ($W_{12n-12,A}$ à $W_{12n+11,B}$) que contient la séquence de données modulées par impulsions codées et des premiers mots de contrôle ($Q_{12n}$ à $Q_{12n+3}$) produits à partir de ces séquences et associés avec elles, chacun desdits seconds blocs de correction d'erreurs ayant été dérivé en soumettant lesdits mots de chacun desdits premiers blocs de correction

14

d'erreurs à des retards différents respectifs de manière à imbriquer lesdits mots, et chacun desdits seconds blocs de correction d'erreurs consistant en plusieurs mots de données ($W_{12n-12,A}$ à $W_{12n11-12(27D),B}$) dont chacun est inclus dans l'un différent dudit premier bloc de correction d'erreurs et des seconds mots de contrôle ($P_{12n}$ à $P_{12n+3}$) produits à partir de ces blocs associés avec eux, le procédé de correction d'erreurs comprenant les phases: d'un premier décodage desdits seconds blocs de correction d'erreurs dans un premier étage (21); ledit premier décodage consistant à détecter l'état d'erreur desdits mots de données dans lesdits seconds blocs de correction d'erreurs et à ajouter un indicateur respectif à chaque mot de données erroné; de désimbrication desdits mots de données pour reformer lesdits premiers blocs de correction d'erreurs, d'un second décodage desdits premiers blocs de correction d'erreurs dans un second étage (23) et de traitement desdits mots sur la base desdits indicateurs de manière à corriger ou à compenser lesdits mots de données erronés; caractérisé en ce que: ledit premier décodage consiste à détecter l'un de plus de deux types d'état d'erreurs comme l'absence d'erreur, une erreur de mot, deux erreurs de mots dans lesdits seconds blocs de correction d'erreurs; à corriger au moins lesdites erreurs d'un mot; et à additionner un indicateur respectif (N1, N2, N3) consistant en plusieurs bits et correspondant respectivement auxdits types d'état d'erreur pour chacun des mots de données de manière à distinguer ledit état d'erreur, ledit second décodage, consistant à corriger d'autres erreurs; et ledit traitement desdits mots de données consistant en outre à déterminer le type desdits indicateurs et à traiter lesdits mots de données sur la base du résultat de ladite discrimination de manière à corriger chacun desdits mots de données erronés quand le nombre desdits mots de données erronés est discriminé comme se situant dans la capacité de correction d'erreurs et dans le cas contraire, à compenser chacun desdits mots de données erronés.

2. Procédé selon la revendication 1, dans lequel le nombre des indicateurs les plus fiables parmi les indicateurs ajoutés dans le premier étage (21) et que contient l'un desdits premiers blocs de correction d'erreurs est déterminé pendant ledit décodage dans le second étage (23) de manière à juger si une correction d'erreur est possible ou non.

3. Procédé selon la revendication 1, dans lequel, lorsqu'une correction d'erreur est impossible dans ledit décodage dudit second étage (23), en fonction du degré de fiabilité des indicateurs dans le bloc de correction d'erreurs utilisé, des indicateurs sont ajoutés à tous les mots que contient le bloc commun de correction d'erreurs, ou les indicateurs ajoutés pendant le décodage dans le second étage (23) restent inchangés.

4. Procédé selon la revendication 1, dans lequel lesdits seconds mots de contrôle ($P_{12n}$ à $P_{12n3}$) dans lesdits seconds blocs de correction d'erreurs sont produits chacun à partir desdits mots de donnée ($W_{12n-12,A}$ à $W_{12n+11-12(27D),B}$) et desdits premiers mots de contrôle ($Q_{12n}$ à $Q_{12n+3}$).

5. Procédé selon la revendication 1, dans lequel lesdits premiers mots de contrôle ($Q_{12n}$ à $Q_{12n+3}$ dans lesdits premiers blocs de correction d'erreurs sont produits chacun à partir desdits mots de données ($W_{12n-12,A}$ à $W_{12n+11,B}$) et desdits seconds mots de contrôle ($P_{12n}$ à $P_{12n+3}$).

# F I G. 1A

| | | |
|---|---|---|
| (L6n) | W12n, A → | W12n-12,A |
| | W12n, B → | W12n-12,B |
| (R6n) | W12n+1,A → | W12n+1-12,A |
| | W12n+1,B → | W12n+1-12,B |
| (L6n+1) | W12n+2,A → | W12n+4-12,A |
| | W12n+2,B → | W12n+4-12,B |
| (R6n+1) | W12n+3,A → | W12n+5-12,A |
| | W12n+3,B → | W12n+5-12,B |
| (L6n+2) | W12n+4,A → | W12n+8-12,A |
| | W12n+4,B → | W12n+8-12,B |
| (R6n+2) | W12n+5,A → | W12n+9-12,A |
| | W12n+5,B → | W12n+9-12,B |
| (L6n+3) | W12n+6,A → | W12n+2,A |
| | W12n+6,B → | W12n+2,B |
| (R6n+3) | W12n+7,A → | W12n+3,A |
| | W12n+7,B → | W12n+3,B |
| (L6n+4) | W12n+8,A → | W12n+6,A |
| | W12n+8,B → | W12n+6,B |
| (R6n+4) | W12n+9,A → | W12n+7,A |
| | W12n+9,B → | W12n+7,B |
| (L6n+5) | W12n+10,A → | W12n+10,A |
| | W12n+10,B → | W12n+10,B |
| (R6n+5) | W12n+11,A → | W12n+11,A |
| | W12n+11,B → | W12n+11,B |

1

FIG.1A  FIG.1B

8 — ENCODER
Q12n
Q12n+1
Q12n+2
Q12n+3

9

0 072 640

F I G. 1B

| Block | Output |
|---|---|
| 1D | →W12n-12, A |
| 1 | →W12n-12(1D+2), B |
| 2D | →W12n+1-12(2D+1), A |
| 3D | →W12n+1-12(3D+2), B |
| 4D | →W12n+4-12(4D+1), A |
| 5D | →W12n+4-12(5D+2), B |
| 6D | →W12n+5-12(6D+1), A |
| 7D | →W12n+5-12(7D+2), B |
| 8D | →W12n+8-12(8D+1), A |
| 9D | →W12n+8-12(9D+2), B |
| 10D | →W12n+9-12(10D+1), A |
| 11D | →W12n+9-12(11D+2), B |
| 12D | →Q12n-12(12D) |
| 13D | →Q12n+1-12(13D+1) |
| 14D | →Q12n+2-12(14D) |
| 15D | →Q12n+3-12(15D+1) |
| 16D | →W12n+2-12(16D), A |
| 17D | →W12n+2-12(17D+1), B |
| 18D | →W12n+3-12(18D), A |
| 19D | →W12n+3-12(19D+1), B |
| 20D | →W12n+6-12(20D), A |
| 21D | →W12n+6-12(21D+1), B |
| 22D | →W12n+7-12(22D), A |
| 23D | →W12n+7-12(23D+1), B |
| 24D | →W12n+10-12(24D), A |
| 25D | →W12n+10-12(25D+1), B |
| 26D | →W12n+11-12(26D), A |
| 27D | →W12n+11-12(27D+1), B |

ENCODER  10

P12n → P12n
P12n+1 → $\overline{P12n+1-12}$
P12n+2 → $\overline{P12n+2}$
P12n+3 → $\overline{P12n+3-12}$

9

11

12 13 14 15

2

## F I G. 2

|16 Bits|

| SYNC | U₁ | U₂ | U₃ | U₄ | U₅ | U₆ | U₇ | U₈ | ---- | U₂₇ | U₂₈ | U₂₉ | U₃₀ | U₃₁ | U₃₂ |

— One Transmission Block   ( 8×32+16 = 272 Bits ) —

## F I G. 5

$$
H_{c2} \cdot V^T = \begin{bmatrix} S_{20} \\ S_{21} \\ S_{22} \\ S_{23} \end{bmatrix}
$$

$$
= \begin{bmatrix} \alpha^{27} & \alpha^{26} & \alpha^{25} & \alpha^{24} & \alpha^{23} & \alpha^{22} & --- & \alpha^{4} & \alpha^{3} & \alpha^{2} & \alpha^{1} \\ \alpha^{54} & \alpha^{52} & \alpha^{50} & \alpha^{48} & \alpha^{46} & \alpha^{44} & --- & \alpha^{8} & \alpha^{6} & \alpha^{4} & \alpha^{2} \\ \alpha^{81} & \alpha^{78} & \alpha^{75} & \alpha^{72} & \alpha^{69} & \alpha^{66} & --- & \alpha^{12} & \alpha^{9} & \alpha^{6} & \alpha^{3} \end{bmatrix}
\begin{bmatrix}
W_{12n-12,A} \\
W_{12n-12,B} \\
W_{12n+1-12,A} \\
W_{12n+1-12,B} \\
W_{12n+4-12,A} \\
W_{12n+4-12,B} \\
W_{12n+5-12,A} \\
W_{12n+5-12,B} \\
W_{12n+8-12,A} \\
W_{12n+8-12,B} \\
W_{12n+9-12,A} \\
W_{12n+9-12,B} \\
W_{12n+2,A} \\
W_{12n+2,B} \\
W_{12n+3,A} \\
W_{12n+3,B} \\
W_{12n+6,A} \\
W_{12n+6,B} \\
W_{12n+7,A} \\
W_{12n+7,B} \\
W_{12n+10,A} \\
W_{12n+10,B} \\
W_{12n+11,A} \\
W_{12n+11,B} \\
Q_{12n} \\
Q_{12n+1} \\
Q_{12n+2} \\
Q_{12n+3}
\end{bmatrix}
$$

F I G. 3A

F I G. 3B

DECODER (Hc2)

W12n-12(27D+2), A
W12n-12(27D+2), B
W12n+1-12(27D+2), A
W12n+1-12(27D+2), B
W12n+2-12(27D+2), A
W12n+2-12(27D+2), B
W12n+3-12(27D+2), A
W12n+3-12(27D+2), B
W12n+4-12(27D+2), A
W12n+4-12(27D+2), B
W12n+5-12(27D+2), A
W12n+5-12(27D+2), B
W12n+6-12(27D+2), A
W12n+6-12(27D+2), B
W12n+7-12(27D+2), A
W12n+7-12(27D+2), B
W12n+8-12(27D+2), A
W12n+8-12(27D+2), B
W12n+9-12(27D+2), A
W12n+9-12(27D+2), B
W12n+10-12(27D+2), A
W12n+10-12(27D+2), B
W12n+11-12(27D+2), A
W12n+11-12(27D+2), B

24

23

22

FIG.3A  FIG.3B

$$H_{c1} \cdot V^T = \begin{bmatrix} S_{10} \\ S_{11} \\ S_{12} \\ S_{13} \end{bmatrix}$$

FIG. 4

$$= \begin{bmatrix} \alpha^{31} & \alpha^{30} & \alpha^{29} & \alpha^{28} & \alpha^{27} & \cdots & \alpha^4 & \alpha^3 & \alpha^2 & \alpha^1 & | \\ \alpha^{62} & \alpha^{60} & \alpha^{58} & \alpha^{56} & \alpha^{54} & \cdots & \alpha^8 & \alpha^6 & \alpha^4 & \alpha^2 & | \\ \alpha^{93} & \alpha^{90} & \alpha^{87} & \alpha^{84} & \alpha^{81} & \cdots & \alpha^{12} & \alpha^9 & \alpha^6 & \alpha^3 & | \end{bmatrix} \begin{bmatrix} W_{12n-12,A} \\ W_{12n-12(1D+1),B} \\ W_{12n+1-12(2D+1),A} \\ W_{12n+1-12(3D+1),B} \\ W_{12n+4-12(4D+1),A} \\ W_{12n+4-12(5D+1),B} \\ W_{12n+5-12(6D+1),A} \\ W_{12n+5-12(7D+1),B} \\ W_{12n+8-12(8D+1),A} \\ W_{12n+8-12(9D+1),B} \\ W_{12n+9-12(10D+1),A} \\ W_{12n+9-12(11D+1),B} \\ Q_{12n+12\ (12D)} \\ Q_{12n+1-12(13D)} \\ Q_{12n+2-12(14D)} \\ Q_{12n+3-12(15D)} \\ W_{12n+2-12(16D),A} \\ W_{12n+2-12(17D),B} \\ W_{12n+3-12(18D),A} \\ W_{12n+3-12(19D),B} \\ W_{12n+6-12(20D),A} \\ W_{12n+6-12(21D),B} \\ W_{12n+7-12(22D),A} \\ W_{12n+7-12(23D),B} \\ W_{12n+10-12(24D),A} \\ W_{12n+10-12(25D),B} \\ W_{12n+11-12(26D),A} \\ W_{12n+11-12(27D),B} \\ P_{12n} \\ P_{12n+1} \\ P_{12n+2} \\ P_{12n+3} \end{bmatrix}$$

FIG. 6

FIG. 7

FIG. 8